(19) **Europäisches Patentamt**
**European Patent Office**
**Office européen des brevets**

(11) **EP 3 899 087 B1**

(12) **EUROPEAN PATENT SPECIFICATION**

(45) Date of publication and mention
of the grant of the patent:
**27.11.2024 Bulletin 2024/48**

(21) Application number: **19898242.3**

(22) Date of filing: **25.10.2019**

(51) International Patent Classification (IPC):
*H01L 21/66* (2006.01)   *H01L 21/306* (2006.01)
*H01L 21/67* (2006.01)

(52) Cooperative Patent Classification (CPC):
**H01L 22/12; H01L 22/20**

(86) International application number:
**PCT/US2019/058097**

(87) International publication number:
**WO 2020/131216 (25.06.2020 Gazette 2020/26)**

(54) **BACKSIDE COATING FOR TRANSPARENT SUBSTRATE**

RÜCKSEITIGE BESCHICHTUNG FÜR TRANSPARENTES SUBSTRAT

REVÊTEMENT DE FACE ARRIÈRE POUR SUBSTRAT TRANSPARENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.12.2018 US 201862780796 P**

(43) Date of publication of application:
**27.10.2021 Bulletin 2021/43**

(73) Proprietor: **Applied Materials, Inc.**
**Santa Clara, California 95054 (US)**

(72) Inventors:
• **DOSHAY, Sage Toko Garrett**
**Santa Clara, California 95054 (US)**
• **MEYER TIMMERMAN THIJSSEN, Rutger**
**Santa Clara, California 95054 (US)**
• **GODET, Ludovic**
**Santa Clara, California 95054 (US)**
• **ZHU, Mingwei**
**Santa Clara, California 95054 (US)**
• **ARGAMAN, Naamah**
**Santa Clara, California 95054 (US)**
• **MCMILLAN, Wayne**
**Santa Clara, California 95054 (US)**

• **KRISHNAN, Siddarth**
**Santa Clara, California 95054 (US)**

(74) Representative: **Zimmermann & Partner**
**Patentanwälte mbB**
**Postfach 330 920**
**80069 München (DE)**

(56) References cited:
JP-A- H0 790 583    JP-A- H06 265 722
US-A1- 2005 116 614   US-A1- 2010 240 195
US-A1- 2014 273 459   US-B2- 7 015 538
US-B2- 8 748 219

• **BUSTA H H ED - ASPNES D E ET AL: "END-
POINT DETECTION WITH LASER
INTERFEROMETRY", OPTICAL
CHARACTERIZATION TECHNIQUES FOR
SEMICONDUCTOR TECHNOLOGY. SAN JOSE,
APRIL 1 - 2 1981; [PROCEEDINGS OF THE
SOCIETY OF PHOTO-OPTICAL
INSTRUMENTATION ENGINEERS],
BELLINGHAM, S.P.I.E, US, vol. VOL. 276, 1 April
1981 (1981-04-01), pages 164 - 169, XP000842379**

**Description**

**CROSS-REFERENCE TO RELATED APPLICATIONS**

This application claims benefit of United States Provisional Patent Application number 62/780,796, filed December 17, 2018.

**BACKGROUND**

Field

Embodiments of the present disclosure generally relate to processing transparent substrates, and more specifically to films deposited on transparent substrates to increase an opacity and/or reflectivity of the transparent substrate.

**Description of the Related Art**

Conventional substrate processing equipment utilizes optical sensors, such as lasers, to identify and align substrates for processing therein. However, optical sensors cannot detect a transparent substrate because light from the optical sensor passes through the transparent substrate. A film may be deposited on the substrate to improve detection of the substrate. However, the film can cause bowing of the substrate which interferes with the optical sensors and can result in damage to damage to devices built on the substrate.

An example of a film deposited on a transparent substrate is disclosed in US 2005/116614 A1. The film has a thickness $T = \lambda/(2n)$, where $\lambda$ is the wavelength of reflected light and $n$ is the refractive index of the film. The wavelength $\lambda$ corresponds to that of the light emitted by a laser.

An example of a method of depositing a film is disclosed in US 2010/240195 A1. The method comprises a step of depositing a first, a second, and a third film on a substrate, wherein the layers are combined to form a triple-layer film. The thickness of each film is determined by its refractive index and the wavelength of a sensor.

What is needed in the art is an improved film for processing substrates.

**SUMMARY**

In an aspect of the present invention, a method of depositing a film according to claim 1 is provided.

Preferred embodiments of the method are provided according to the dependent claims.

By means of the method, an apparatus may be provided which includes the transparent substrate having a first side and a second side opposite the first side, with the film is deposited on the second side,i.e. backside, of the substrate , wherein the film has the target thickness.

**BRIEF DESCRIPTION OF THE DRAWINGS**

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings may admit to other equally effective aspects of the disclosure.

Figure 1 illustrates operations of the method for forming a film on a substrate.

Figure 2 illustrates the apparatus.

To facilitate understanding, identical reference numerals have been used, where possible, to designate identical elements that are common to the figures. It is contemplated that elements and features of one embodiment may be beneficially incorporated in other embodiments without further recitation.

**DETAILED DESCRIPTION**

Embodiments described herein relate to semiconductor processing. More specifically, embodiments described herein relate to processing of transparent substrates. A film is deposited on a backside of the transparent substrate. A thickness of the film is determined such that the film reflects particular wavelengths of light and substantially prevents bowing of the substrate. The film provides constructive interference to the particular wavelengths of light.

One or more optical sensors, which emit light of a particular wavelength, are used to detect and align substrates for processing. When a transparent substrate is to be processed, the one or more optical sensors cannot detect a transparent substrate because light from the optical sensor passes through the transparent substrate. Thus, a film is deposited on a backside of the transparent substrate to increase a reflectivity or opacity of the substrate by providing constructive interference of the light from the optical sensors. The backside of the substrate is opposite a side of the substrate where one or more devices are formed.

In one case, the film can be deposited on the substrate using a chemical vapor deposition (CVD) process. In another case, the film can be deposited on the substrate using a plasma enhanced chemical vapor deposition (PECVD) process. It is contemplated that other processes, such as physical vapor deposition, can be used to deposit the film on the substrate.

In one embodiment, which can be combined with one or more embodiments described above, the film deposited on the substrate is a silicon containing material, such as amorphous silicon or silicon nitride. The silicon nitride can be used to increase a reflectivity of the substrate. An amorphous silicon layer can be used to increase an opacity of the substrate. The film on the backside of the substrate can be fabricated from a material other than silicon. Any reflectivity or opacity enhancing material may be used for the film. In some embodiments, which can be combined with one or more embodiments described above, the film is fabricated from a single layer. In other embodiments, the film is fabricated from one or more layers of the same or a different material.

A thickness of the film deposited on the backside of the substrate is determined based on a wavelength of the light emitted from the sensor. A minimum thickness of the film is determined by:

$$T = \frac{\lambda}{2n}$$

where T is the thickness of the film, $\lambda$ is a wavelength of light emitted from the sensor, and n is a refractive index of the material of the film. The refractive index, n, is a ratio of a speed of light within the material of the film to a speed of light in a vacuum.

In one embodiment, which can be combined with one or more embodiments described above, a thickness of the film deposited on the backside of the substrate is between about 200 nm and about 500 nm, for example, between about 300 nm and about 450 nm, such as about 350 nm. In one embodiment, which can be combined with one or more embodiments described above, a wavelength of the light emitted from the sensor is between about 300 nm and about 800 nm, for example between about 500 nm and about 700 nm, such as about 650 nm.

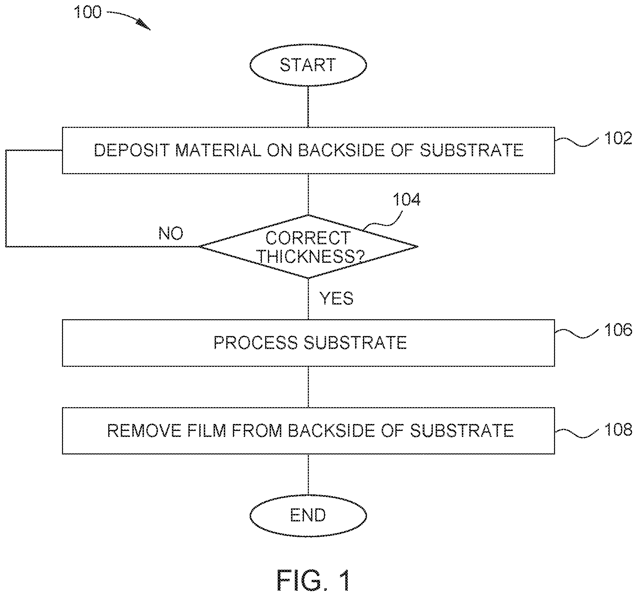

Figure 1 illustrates operations of a method 100 for forming a film on a substrate. As shown, the method 100 begins at operation 102 where a material is deposited on a backside of the substrate to form a film. At operation 104, a sensor, such as a laser, is used to determine a thickness of the film deposited on the substrate. If the thickness of the film does not satisfy the equation above, the method 100 proceeds to operation 102 where additional material is deposited on the backside of the substrate to increase the thickness of the film. The film on the backside of the substrate enables constructive interference of light passing through the substrate, thereby increasing a reflectivity of the light. The reflected light from the backside film can be detected by one or more sensors used to align and process the substrate in a process chamber.

Once the thickness of the film satisfies the equation above, the method 100 proceeds to operation 106 where the substrate is processed. The substrate can be processed by depositing one or more layers on a surface of the substrate opposite the backside of the substrate. The one or more layers may form one or more devices on the substrate.

At operation 108, the film is removed from the backside of the substrate. The film can be removed using a wet etch technique. Other processes for removing the film from the backside of the substrate include dry etching, laser etching, and others. A masking layer may be deposited over the devices formed on the substrate to substantially reduce damage to the devices during the removal operation 108.

The substrate is fabricated from a material different than a material utilized to form the one or more devices. In this way, a selective etch can be utilized to remove the film from the backside while substantially preventing damage to the one or more devices.

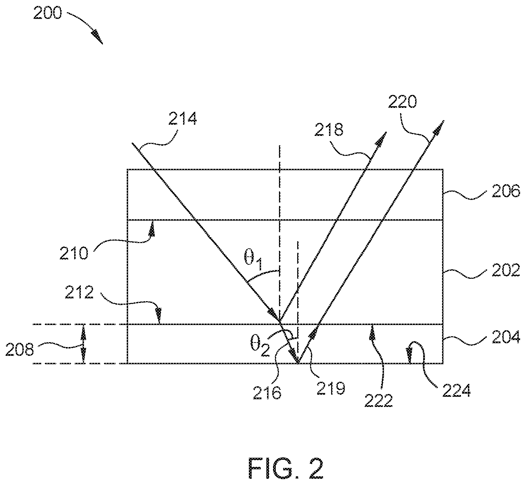

Figure 2 illustrates an apparatus 200.

The apparatus 200 includes a transparent substrate 202 including a first surface 210 and a second surface 212 opposite and substantially parallel to the first surface 210. The transparent substrate 202 is fabricated from a transparent material such as glass or fused silica.

The apparatus 200 can be formed according to the method 100 illustrated in FIG. 1.

A backside film 204 is deposited on and adhered to the second surface 212 of the transparent substrate 202. The backside film 204 has a first surface 222 adjacent to the second surface 212 of the substrate 202 and a second surface 224 opposite and substantially parallel to the first surface 222 of the backside film 204. The backside film 204 comprises a silicon containing material, such as amorphous silicon or silicon nitride. A thickness 208 of the backside film 204 corresponds to a refractive index of the material used to form the backside film 204. The thickness 208 also corresponds to a wavelength of light emitted from a sensor used to detect and align the substrate 202. The backside film 204 increases a reflectivity of the transparent substrate 202 while substantially preventing or substantially reducing an amount of bowing of the transparent substrate 202 caused by the backside film 204.

One or more layers 206 are deposited on and adhered to the first surface 210 of the transparent substrate 202. The one or more layers 206 can be deposited on the transparent substrate 202 utilizing, for example, a CVD process, a PECVD process, or a physical vapor deposition (PVD) process. Other deposition processes may be utilized.

After the one or more layers 206 are deposited on the transparent substrate 202, the backside film 204 is removed utilizing a selective etch process, such as a wet etch. The selective etch process substantially removes the backside film 204 while minimizing damage to the transparent substrate 202 and the one or more layers 206.

In operation, light is projected from a sensor toward the substrate 202 along a path 214. While the path 214 is shown at an angle $\theta_1$ from a plane that is substantially normal to the first surface 222 of the film 204, it is contemplated that the path 214 is substantially perpendicular to the first surface 222. That is, $\theta_1$ may be sub-

stantially zero. When the light intersects the first surface 222 of the film 204, a first portion of the light is reflected along a first reflective path 218. A second portion of the light is refracted at the first surface 222 of the film 204 and travels through the film 204 along a path 216. The path 216 is an angle $\theta_2$ from a plane that is substantially normal to the second surface 224 of the film 204, which is different than $\theta_1$. The second portion of the light reflects off of the second surface 224 of the film 204 and travels along a path 219. When the second portion of the light intersects the first surface 222 of the film 204, the second portion of the light is refracted to travel along a second reflective path 220. The second reflective path 220 is substantially parallel to the first reflective path 218 of the first portion of the light, and light. only a portion of the second portion of light reflects off of the second surface of the second surface 224 of the film 204.

The film 204 provides constructive interference of the light from the sensor when a length of the second reflective path 220 is an integer multiple of the wavelength $\lambda$ of the light emitted from the sensor. The length of the second reflective path 220 is determinable by

$$L = 2n\,cos(\theta_2)$$

where $L$ is the length of the second reflective path 220 and $n$ is the refractive index of the material of the backside film 204.

Embodiments described herein provide a backside coating for transparent substrates. Advantageously, the backside coating on the substrate enables use of one or more sensors to detect and align the substrate in a process chamber. A thickness of the backside coating enables a particular wavelength of light emitted from the one or more sensors to be reflected from the coating while substantially preventing bowing of the substrate.

While the foregoing is directed to embodiments of the present disclosure, other and further embodiments of the disclosure may be devised without departing from the scope determined by the claims that follow.

**Claims**

1. A method of depositing a film, comprising:

   obtaining a wavelength of light emitted from a sensor;
   identifying a refractive index of a material;
   determining a target thickness of the material by dividing the wavelength of the light emitted from the sensor by two times the refractive index of the material; and
   depositing the material on a substrate to form a film on a backside of the substrate;

   determining a thickness of the film deposited on the substrate using the sensor;
if the thickness of the film is less than the target thickness, deposit additional material on the backside of the substrate to increase the thickness of the film;
once the thickness of the film has the target thickness, processing the substrate; and
removing the film from the backside of the substrate.

2. The method of claim 1, wherein the wavelength of the light emitted from the sensor is between about 500 nm and about 700 nm.

3. The method of claim 1, further comprising:
   depositing one or more layers on a side of the substrate opposite the film.

4. The method of claim 1, further comprising:
   performing a selective etch to remove the film from the substrate.

5. The method of claim 1, wherein the target thickness is between about 300 nm and about 450 nm.

6. The method of claim 5, wherein the silicon containing material comprises silicon nitride.

7. The method of claim 5, wherein the wavelength of the light emitted from the sensor is between about 500 nm and about 700 nm.

8. The method of claim 5, further comprising:
   depositing one or more layers on a side of the substrate opposite the film.

9. The method of claim 5, further comprising:
   performing a selective etch to remove the film from the substrate.

10. The method of claim 5, wherein the film increases at least one of a reflectivity and an opacity of the substrate.

**Patentansprüche**

1. Verfahren zum Aufbringen eines Films, umfassend:

   Erhalten einer Wellenlänge von Licht, das von einem Sensor emittiert wird;
   Identifizieren eines Brechungsindex eines Materials;
   Bestimmen einer Zieldicke des Materials durch Dividieren der Wellenlänge des von dem Sensor emittierten Lichts durch das Zweifache des Brechungsindex des Materials; und
   Aufbringen des Materials auf ein Substrat, um einen Film auf einer Rückseite des Substrats zu bilden;

Bestimmen einer Dicke des auf dem Substrat aufgebrachten Films unter Verwendung des Sensors;
falls die Dicke des Films geringer ist als die Zieldicke, Aufbringen von zusätzlichem Material auf der Rückseite des Substrats, um die Dicke des Films zu erhöhen;
Verarbeiten des Substrats, sobald die Dicke des Films die Zieldicke aufweist; und
Entfernen des Films von der Rückseite des Substrats.

2. Verfahren nach Anspruch 1, wobei die Wellenlänge des vom Sensor emittierten Lichts zwischen etwa 500 nm und etwa 700 nm liegt.

3. Verfahren nach Anspruch 1, ferner umfassend:
Aufbringen einer oder mehrerer Schichten auf einer Seite des Substrats, die dem Film gegenüberliegt.

4. Verfahren nach Anspruch 1, ferner umfassend:
Durchführen eines selektiven Ätzens, um den Film vom Substrat zu entfernen.

5. Verfahren nach Anspruch 1, wobei die Zieldicke zwischen etwa 300 nm und etwa 450 nm liegt.

6. Verfahren nach Anspruch 5, wobei das Silizium enthaltende Material Siliziumnitrid umfasst.

7. Verfahren nach Anspruch 5, wobei die Wellenlänge des vom Sensor emittierten Lichts zwischen etwa 500 nm und etwa 700 nm liegt.

8. Verfahren nach Anspruch 5, ferner umfassend:
Aufbringen einer oder mehrerer Schichten auf einer Seite des Substrats, die dem Film gegenüberliegt.

9. Verfahren nach Anspruch 5, ferner umfassend:
Durchführen eines selektiven Ätzens, um den Film von dem Substrat zu entfernen.

10. Verfahren nach Anspruch 5, wobei der Film mindestens eines von einer Reflektivität und einer Opazität des Substrats erhöht.

**Revendications**

1. Procédé de dépôt d'un film, comprenant :

l'obtention d'une longueur d'onde de la lumière émise par un capteur ;
l'identification de l'indice de réfraction d'un matériau ;
la détermination d'une épaisseur cible du matériau en divisant la longueur d'onde de la lumière émise par le capteur par deux fois l'indice de réfraction du matériau ; et
le dépôt du matériau sur un substrat pour former un film sur la face arrière du substrat ;
la détermination de l'épaisseur du film déposé sur le substrat à l'aide du capteur ;
si l'épaisseur du film est inférieure à l'épaisseur cible, le dépôt d'un matériau supplémentaire sur la face arrière du substrat afin d'augmenter l'épaisseur du film ;
une fois que l'épaisseur du film a atteint l'épaisseur cible, le traitement du substrat ; et
le retrait du film de la face arrière du substrat.

2. Procédé selon la revendication 1, dans lequel la longueur d'onde de la lumière émise par le capteur est comprise entre environ 500 nm et environ 700 nm.

3. Procédé selon la revendication 1, comprenant en outre :
le dépôt d'une ou plusieurs couches sur la face du substrat opposée au film.

4. Procédé selon la revendication 1, comprenant en outre :
le fait d'effectuer une gravure sélective pour retirer le film du substrat.

5. Procédé selon la revendication 1, dans lequel l'épaisseur de la cible est comprise entre environ 300 nm et environ 450 nm.

6. Procédé selon la revendication 5, dans lequel le matériau contenant du silicium comprend du nitrure de silicium.

7. Procédé selon la revendication 5, dans lequel la longueur d'onde de la lumière émise par le capteur est comprise entre environ 500 nm et environ 700 nm.

8. Procédé selon la revendication 5, comprenant en outre :
le dépôt d'une ou plusieurs couches sur la face du substrat opposée au film.

9. Procédé selon la revendication 5, comprenant en outre :
le fait d'effectuer une gravure sélective pour retirer le film du substrat.

10. Procédé selon la revendication 5, dans lequel le film augmente au moins l'une de la réflectivité et de l'opacité du substrat.

100

START

DEPOSIT MATERIAL ON BACKSIDE OF SUBSTRATE ⟋ 102

104

NO — CORRECT THICKNESS?

YES

PROCESS SUBSTRATE ⟋ 106

REMOVE FILM FROM BACKSIDE OF SUBSTRATE ⟋ 108

END

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62780796
- US 2005116614 A1

- US 2010240195 A1